(19) Europäisches Patentamt
European Patent Office
Office européen des brevets

(11) Publication number : **0 277 038 B1**

# (12) EUROPEAN PATENT SPECIFICATION

(45) Date of publication of patent specification : **23.11.94 Bulletin 94/47**

(51) Int. Cl.$^5$ : **G03F 3/10**

(21) Application number : **88300796.5**

(22) Date of filing : **29.01.88**

## (54) Multi-color transfer image forming method.

(30) Priority : **30.01.87 JP 19715/87**
**08.12.87 JP 309981/87**

(43) Date of publication of application : **03.08.88 Bulletin 88/31**

(45) Publication of the grant of the patent : **23.11.94 Bulletin 94/47**

(84) Designated Contracting States : **DE FR GB IT NL**

(56) References cited :
**EP-A- 0 115 899**
**EP-A- 0 197 396**
**DE-A- 2 623 925**
**US-A- 3 136 637**
**US-A- 4 053 313**

(73) Proprietor : **KONICA CORPORATION**
**26-2, Nishishinjuku 1-chome,**
**Shinjuku-ku**
**Tokyo 160 (JP)**
Proprietor : **MITSUBISHI KASEI CORPORATION**
**5-2, Marunouchi 2-chome**
**Chiyoda-ku**
**Tokyo 100 (JP)**

(72) Inventor : **Shimizu, Kunio**
**c/o Konica Corporation**
**1, Sakuramachi**
**Hino-shi Tokyo (JP)**
Inventor : **Sasa, Nobumasa**
**c/o Konica Corporation**
**1, Sakuramachi**
**Hino-shi Tokyo (JP)**
Inventor : **Watanabe, Manabu**
**c/o Konica Corporation**
**1, Sakuramachi**
**Hino-shi Tokyo (JP)**
Inventor : **Ide, Hiroshi**
**1-17-2-10, Nishi-Hashimoto**
**Sagamihara-shi Kanagawa-ken (JP)**
Inventor : **Mayama, Shinya**
**23-4, Tanacho**
**Midori-ku**
**Yokohama-shi Kanagawa-ken (JP)**

(74) Representative : **Brock, Peter William et al**
**URQUHART-DYKES & LORD**
**91 Wimpole Street**
**London W1M 8AH (GB)**

**EP 0 277 038 B1**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### BACKGROUND OF THE INVENTION

This invention relates to a multi-color transfer image forming method to be used for formation of color proof, etc.

In carrying out color printing, in either of lithography, letter press or gravure, the half tone method is used, and color-resolved dots, positive or negative plate is required.

For saving of labor and time for proofreading performed prior to such practical printing, a color sheet for proofreading, namely color proof, has been generally known.

Concerning layer constitution and image forming method for such color proof, various proposals have been made. Typical transfer system of color proof are (1) the method in which a colored image is formed by transferring a photosensitive layer containing a colorant onto a support and repeating exposure and developing; (2) the method in which a photosensitive tacky layer is laminated onto a support and a toner is applied after exposure; and (3) the method in which monochromatic images formed on a color sheet are successively transferred onto an image receiving layer, and retransferred onto an image receiving member.

However, the above respective methods are complicated in process and require enormous labors. Also, particularly the colored image layer transferred, partly because it takes the form embedded in the receiving layer in the method of (3), had lustre not only on the surface of the transferred image but also on the non-image portion, and therefore gave a feeling of quality or image quality different from practtical printed matter. Accordingly, in order to make the image quality approximate to that of practical printed matter as possible, the transferred image surface is required to be subjected to matting treatment, and even if such treatment may be effected, the feeling of quality given was different from that of practical printed matter.

US-A-4 053 313 describes an image reproduction process using an imagewise exposed photosensitive element comprising a solvent-processable photosensitive layer and a non-photosensitive elastomeric tonable contiguous layer. Color proofs may be made by the process by exposing the element, washing away the exposed or unexposed areas according to the photosensitive layer composition and then toning the remaining areas of the elastomeric layer with a suitably pigmented toner. A series of pigmented images may be combined to provide a color proof.

EP-A-0 197 396 discloses a method for preparing a color proof by using a photosensitive material having a photosensitive layer and an upper layer which is adhesive. The layers are transferred to an image receiving material followed by exposure and development. Subsequently further photosensitive layers having different colors are succesively transferred to the same image receiving material and the same procedures are repeated to provide a multi-color final image. The photosensitive layers are transferred to the image receiving material before development is carried out so that the support for the image receiving material must be resistant to the developerd in solution; normal printing paper cannot be used and realistic color proofs are not obtained.

### SUMMARY OF THE INVENTION

According to the present invention there is provided a multi-color transfer image forming method, which comprises subjecting to imagewise exposure an image forming material having a support and a recording layer thereon, characterized in that said recording layer comprises two layers including a colorant and photosensitive material whose solubility with respect to aqueous based solutions changes on exposure to actinic radiation, the layer which is remotest from the support on which the recording layer is applied, being adhesive to an image receiving member; the material is developed using an aqueous developer, leaving the support exposed in the non image parts and leaving a colored image in the image parts, said material is laminated to an image receiving member with peel-off of the support, so that said colored image adheres to the image receiving member with the outermost adhesive layer of said colored image, and thereafter at least one further image obtained by exposure and development of said image forming material, having a colorant of a different hue is transferred to said same image receiving member having said colored image thereon whereby a surface of said image receiving member is left exposed in non-image portions of said multi-color transfer image.

In the present invention when a colored image is formed the outermost layer of the colored image forming material has a layer adherable to an image receiving member, namely an adhesive layer, and therefore when, for example, heat transfer is effected after superposing the adhesive layer onto the image receiving member, a photosensitive composition layer is exposed directly under the naked state on the outermost layer of the color proof finally obtained. Therefore, the outermost surface of the photo- sensitive composition layer has no lustre and gives a quality feeling similar to actual printed matter.

## BRIEF DESCRIPTION OF THE DRAWINGS

Figure 1 is a perspective view of an example layer constitution of a photographic image forming material,
Figure 2 is a perspective view of a color proof finally obtained.

## DESCRIPTION OF THE PREFERRED EMBODIMENTS

The present invention is described in more detail below.

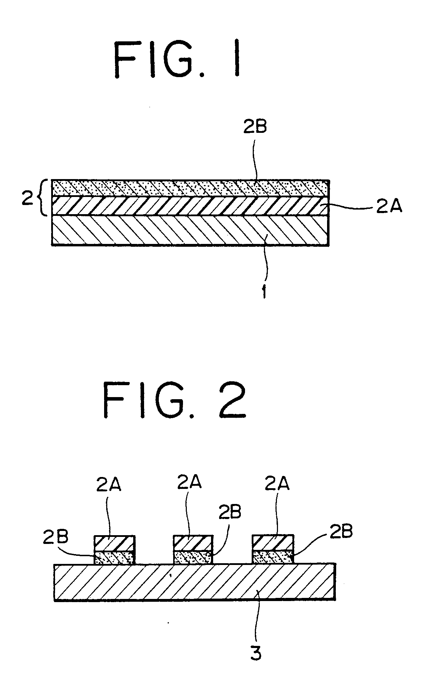

First, the process of the present invention is outlined by referring to Fig. 1 and Fig. 2.

Fig. 1 illustrates the layer constitution of a photosensitive image forming material, having a coloration recording layer 2 through a mold release treated layer or a subbing layer or directly without any such layer on a transparent support 1 such as of polyester, etc. The coloration recording layer 2 comprises at least two layers 2A and 2B, and the layer 2B remotest from the support 1 is made of an adhesive layer. The adhesive layer 2B may be one which can be adhered when the colored image is transferred onto an image receiving member, including in addition to those which can exhibit adhesiveness at room temperature under no treatment, those which can exhibit adhesiveness under some treatment, for example, by giving heat, and also those which can exhibit adhesiveness by activation of the surface by wetting with a solvent, etc, capable of swelling adequately the layer. Preferably, those having thermal fusibility may be employed.

The coloration recording layer 2 contains at least a photosensitive material and a colorant.

As the embodiment of the coloration recording layer 2, the present invention includes various embodiments as described below, but in the embodiment shown in the Figure, the lower layer 2A is the colorant-photosensitive layer containing a colorant and a photosensitive material, and the upper layer 2B is a binder layer exhibiting thermal fusibility.

On such photosensitive image forming material, on the side of the transparent support 1, or on the side of the binder layer 2 if the binder layer 2 is transparent, imagewise exposure is effected. Then, aqueous developing is performed to form a colored image.

Subsequently, with the outermost surface of the photosensitive image forming material having the colored image formed thereon, namely the binder layer 2, being superposed on an image receiving member 3, preferably a paper for printing, heat is given to effect thermal fusion of the binder layer 2, followed by peel-off of the transparent support 1 to effect transfer, thus forming a transferred image on the image receiving member 3 as shown in Fig. 2.

In this invention, the coloration recording layer comprising at least two layers is completely transferred to the image receiving member when the transfer is made.

The embodiments of the coloration recording layer in the present invention are as shown in Table 1.

Table 1

| Embodiment No. | Upper layer | Lower layer |
|---|---|---|
| 1 | Binder | Colorant - photosensitive |
| 2 | Colorant | Photosensitive |
| 3 | " | Colorant - photosensitive |
| 4 | Photosensitive | Colorant |
| 5 | " | Colorant - photosensitive |
| 6 | Colorant, photosensitive | Binder |
| 7 | " | Colorant |
| 8 | " | Photosensitive |
| 9 | " | Colorant - photosensitive |

Also, between the lower layer in Table 1 and the support, other than the mold release treated layer or the subbing layer, various layers shown as the lower layer constitution in Table 1 may be further formed. An example of such constitution may be the case of Embodiment No. 4 in which the upper layer is made a photosensitive layer, the lower layer is made a colorant layer and further, between the lower layer and a support, a colorant-photosensitive layer, etc. is provided

The above colorant layer means a layer containing a colorant such as pigment or dye, the colorant-photosensitive layer means a layer containing both of a colorant and a photosensitive material, and the binder layer means a layer containing none of colorant and photosensitive material. Further, the photosensitive layer is a layer containing no colorant but containing a photosensitive material. In this case, since the colorant layer of the upper layer must have the adhesion function and only a colorant cannot have such adhesion function, it contains some adhesion functional substance. As to the photosensitive layer of the upper layer, in addition to the case when the photosensitive material itself has the adhesion function, an adhesion functional substance other than the photosensitive material may be sometimes added. Further, similarly for the colorant-photosensitive layer of the upper layer, an adhesion functional substance may be also added.

As the support for the photosensitive image forming material to be used in the present invention, a polyester film, particularly a biaxially stretched polyethyleneterephthalate film is preferred with respect to dimensional stability to water and heat, but acetate film, polyvinyl chloride film, polystyrene film, polypropylene may be also available. Further, although these supports may be also used as such, mold release treatment with an appropriate oil repellent substance may be applied or a subbing layer may be provided for improving transferability of the image after image formation.

As the oil repellent substance, there may be included, for example, silicone resin, fluorine resin and fluorine type surfactant, polyolefin, polyamide; while as the subbing layer, there may be employed, for example, those having weak adhesive force with the transparent support such as alcohol-soluble polyamide, alcohol-soluble nylon, a blend of a partially esterified resin of a copolymer of styrene and maleic anhydride with a methoxymethylated nylon, polyvinyl acetate, polyacrylate, copolymer of polymethyl methacrylate and acrylate, polyvinyl chloride, copolymer of vinyl chloride and vinyl acetate, polyvinyl butyrate, cellulose acetate phthalate, methyl cellulose, ethyl cellulose, cellulose diacetate, cellulose triacetate, polyvinyl alcohol.

For enhancing mold releasability, among the above examples, particularly preferred are examples in which a polypropylene layer and/or a polyethylene layer is provided desirably in a thickness thicker than that of the support.

As the method for providing a polypropylene layer or a polyethylene layer on a support, there may be included 1) the so-called dry lamination method in which a solution of polyvinyl acetate, polyvinyl chloride, epoxy

resin, polyurethane type resin, natural rubber or synthetic rubber dissolved in an organic solvent is used as the adhesive, and after these adhesives are applied on the support and dried by hot blow or heating, a polypropylene film or a polyethylene film is superposed and pressure adhered under heating to effect lamination; 2) the so-called hot melt lamination method in which a mixture of a copolymer of ethylene and vinyl acetate or ethylene and an acrylic acid ester, polyamide resin, petroleum resin, rosins, waxes is used as the adhesive, and these adhesives are heated as such and while maintaining the molten state, applied on the support by the doctor blade method, the roll coating method, the gravure method, the reverse roll method, etc., followed immediately by plastering of a polypropylene film or a polyethylene film, and heated to a high temperature, if necessary, before cooling to effect lamination; 3) the so-called extrusion lamination method in which polypropylene or polyethylene is maintained under molten state, extruded into a film through an extruder, and pressure adhered onto the support while this is under molten state to effect lamination; and the so-called co-extrusion method in which a plurality of extruders were used in molding of a film which becomes the support by melt extrusion method, and a polypropylene layer or a polyethylene layer is formed on the support film by molding at one time together with polypropylene or polyethylene under molten state; etc.

The above support may be either transparent or opaque. When the above upper layer is opaque, the support is made transparent and imagewise exposure is required to be effected from the support side, while if the upper layer is transparent, imagewise exposure can be effected on the side of the upper layer.

As the photosensitive composition for the photosensitive material to be used in the present invention, various materials have been known in the art, and commercial products are readily available. Useful photosensitive compositions may include all of the compounds such as monomers, prepolymers and polymers which can undergo chemical changes in molecular structure within a short time when receiving irradiation of active rays, to be changed in solubility relative to solvents, thereby permitting the exposed portion or the non-exposed portion to be dissolved away when a certain kind of solvent is applied. Examples of available photosensitive compositions may include, as the so-called nega-posi type, photocrosslinkable type photosensitive resin system, typically a polyvinyl alcohol esterified with cinnamic acid, a system comprising a mixture of a diazonium salt or its condensate with polyvinyl alcohol, polyvinyl pyrrolidone, polyacrylamide, etc., or a system in which an aromatic azide compound is used as the photocrosslinkable agent and mixed with a binder such as cyclized rubber, etc., and further a photosensitive resin utilizing photoradical polymerization or photoionic polymerization. Also, as the posi-posi type in which solubility at the exposed portion is increased, a photosolubilizing type resin system, typically a combination of naphthoquinonediazide and a novolac resin may be employed.

Commercial products of such photosensitive comositions may include "KPR", "KOR" and "KPER" produced by Eastman Kodak Co., U.S.A.; "AZ-340", "AZ-119" and "AZ-1350" produced by Sippley Co., U.S.A.; "TPR" and "Oka Resist" produced by Tokyo Oka; "FPPR" produced by Fuji Yakuhin, and all of these can be utilized.

Otherwise, it is also possible to use a photosolubilizing type resin system containing a compound capable of generating an acid by irradiation of active rays and a compound having at least one bond decomposable with an acid.

As the photosensitive composition, quinonediazide compounds are useful.

Specifically, there may be preferably employed compounds obtained by condensation of 1,2-benzoquinonediazide-4-sulfonyl chloride, 1,2-naphthoquinonediazide-4-sulfonyl chloride, 1,2-naphthoquinonediazide-6-sulfonyl chloride, or 1,2-naphthoquinonediazide-6-sulfonyl chloride with hydroxyl group- and/or amino group-containing compounds.

Examples of the hydroxyl group-containing compound may include trihydroxybenzopheone, dihydroxyanthraquinone, bisphenol A, phenol novolac resin, resorcin benzaldehyde condensed resin, pyrogallol acetone condensed resin, etc. Examples of the amino group-containing compound may include, for example, aniline, p-aminodiphenylamine, p-aminobenzophenone, 4,4'-diaminodiphenylamine, 4,4-diaminobenzophenone, etc.

Including those written here, concerning quinonediazide compounds, further the descriptions in J. KOSAR, "Light Sensitive System" (Wiley & Sons, New York, 1965) and Nagamatsu and Inui, "Photosensitive Polymers" (Kodansha, 1977) may be followed.

As the coloring substance as the colorant to be used in the present invention, dyes and pigments can be used. Particularly, when used for color correction, pigments and dyes with tones in conformity with the normal colors required there, namely yellow, magenta, cyan and black are required, and otherwise metal powder, white pigment, fluorescent pigment, etc. can be also used. The following examples are some examples of a large number of pigments and dyes known in this field of the art (C.I means color index):

Victoria Pure Blue (C.I 42595)
Auramine O (C.I 41000)
Catilon Brilliant Flavin (C.I basic 13)
Rhodamine GGCP (C.I 45160)

Rhodamine B(C.I 45170)
Safranine OK70:100 (C.I 50240)
Eliograucin X (C.I 42080)
Fast Black HB (C.I 26150)
No.1201 Lionol Yellow (C.I 21090)
Lionol Yellow GRO (C.I 21090)
Simlar Fast yellow 8GF (C.I 21105)
Benzidine Yellow 4T-564D (C.I 21095)
Simlar Fast Red 4015 (C.I 12355)
Lionol Red 7B4401 (C.I 15830)
Fastgen Blue TGR-L (C.I 74160)
Lionol Blue SM (C.I 26150)
Mitsubishi Carbon Black MA-100
Mitsubishi Carbon Black #30, #40, #50

The content of the coloring substance can be determined by the method known to those skilled in the art in view of the optical density aimed at and eliminability relative to the developer. For exmple, in the case of a dye, its content may be suitably 5% to 75% by weight based on a composition of a layer containing the dye, while in the case of a pigment, its content may be suitably 5% to 90% by weight based on a composition of a layer containing the pigment.

The photosensitive material and the colorant as described above have no or poor film forming property, and therefore it is preferable to effect film formation by use of a binder.

As the binder, there can be used polymeric compounds which can form a film and is soluble in a solvent, and can be dissolved or swelled in the developer.

Specific examples of the polymeric compound suitably used in the above coloration recording may include acrylic acid or methacrylic acid and alkyl ester or sulfoalkylester thereof, phenol resin, polyvinyl butyral, polyacrylamide, cellulose derivatives such as ethyl cellulose, cellulose acetate-butyrate, cellulose acetate propionate, cellulose acetate, benzyl cellulose, cellulose propionate, etc., otherwise poystyrene, polyvinyl chloride, chlorinated rubber, polyisobutylene, polybutadiene, plyvinyl acetate, and their copolymers, cellulose acetate, cellulose propionate, cellulose acetate phthalate, etc.

The binder can be used as such in the binder layer shown in the above Table, or as the binder in the colorant layer, the photosensitive layer and the colorant-photosensitive layer.

Also, as the binder to be used for constitution of the upper layer shown in Table 1 or for constitution of the upper layer together with the colorant or the photosensitive material, there may be desirably used (1) a novolac resin, particularly a phenol resin having a weight average molecular weight (Mw) of 3,500 to 500 and a number averave molecular weight (Mn) of 1,o00 to 200, and (2) a copolymer containing at least one of phenolic hydroxyl group, alcoholic hydroxyl group, carboxylic group for transferability of the colored image onto the image receiving member, particularly thermal fusibility.

The novolac resin of the above (1) is inclusive of all compounds having at least one hydrogen atom bonded to an aromatic ring substituted with hyroxyl group, and specifically there can be mentioned, for example, phenol, o-cresol, m-cresol, p-cresol, 3,5-xylenol, 2,4-xylenol, 2,5-xylenol, carvacrol, thymol, catechol, resorcin, hydroquinone, pyrogallol, fluoroglycine, alkyl (having 1 to 8 carbon atoms)-substituted phenol, etc. There may be suitably used novolac type resins obtained by polycondensation between such type of phenols and active carbonyl compounds.

Such active carbonyl compounds may include, for example, aldehydes and ketones, specifically formaldehyde, acetaldehyde, benzaldehyde, acrolein, furfural, acetone, etc.

The polycondensed resin obtained may include phenol formaldehyde novolac resin, m-cresol formaldehyde novolac resin, phenol-m-cresol-formaldehyde co-polycondensed resin, phenol-p-cresol-formaldehyde co-polycondensed resin, m-cresol-p-cresol-formaldehyde co-polycondensed resin, o-cresol-p-cresol-formaldehyde co-polycondensed resin, phenol-o-cresol-m-cresol-formaldehyde co-polycondensed resin, phenol-o-cresol-p-cresol-formaldehyde co-polycondensed resin, phenol-m-cresol-p-cresol-formaldehyde co-polycondensed resin and the like.

On the other hand, as the monomer for obtaining the copolymer (2), there can be included N-(4-hydroxyphenyl)-(meth)acrylamide, N-(2-hydroxyphenyl)-(meth)acrylamide, N-(4-hydroxynaphthyl)-(meth)acrylamide, o-, m-, or p-hydroxyphenyl (meth)acrylate, o-, m- or p-hydroxystyrene, hydroxyethyl (meth)acrylate, hydroxypropyl (meth)acrylate, (meth)acrylic acid, and by copolymerizing other known monomers with this monomer, a desired binder can be obtained. The binder in this case should preferably have a weight average molecular weight of 1,000 to 50,000, particularly 1,000 to 30,000.

Molecular weight of the above resin is measured according to the GPC (gel permeation chromatography)

method. Calculations of number average molecular weight Mn and weight average molecular weight Mw are conducted by the method described in Morio Tsuge, Tatsuya Miyabayashi, Masayuki Tanaka, "Journal of Chemical Society of Japan" p. 800 - 805 (1972), namely the method in which the peaks in the oligomer region are uniformized (centers of the mountain and the valley of peaks are connected).

Also, in the above novolac resin, as the method for confirming the quantitative ratio of different phenols used for its synthesis, pyrolysis gas chromatography (PGC) is used. As to pyrolysis gas chromatography, its principle, apparatus and experimental conditions are described in, for example, "New Experimental Course", vol. 19, Polymeric Chemistry [I], edited by Shin Tsuge, p. 474 - 485 (published by Maruzen, 1978), etc. and the qualitative analytical method of novolac resin by pyrolysis gas chromatography follows the method described in Morio Tsuge, Takashi Tanaka and Masayuki Tanaka "Analytical Chemistry" vol. 18, p. 47 - 52 (1969).

Further, as the binder (3) when constituting the upper layer in Table 1, one comprising a heat-fusible polymer, having water permeability and water insolubility may be also used.

Shortly speaking, during development, it is preferable to use a binder which can permit well permeation of a developer to enable development of the photosensitive layer and is also insoluble in the developer.

Its specific example may be a water-dispersible emulsion.

For example, there may be included single component polymers or copolymers of acrylic and methacrylic acid esters such as methyl ester, ethyl ester, butyl ester, isobutyl ester, hexyl ester, decyl ester, lauryl ester, stearyl ester and cyclohexyl ester; vinyl esters such as vinyl acetate, vinyl propionate, vinyl isononanate, vinyl benzathate, ethylene, dibutylmaleinate, styrol, vinyl chloride, vinyl isobutyl ether, isobutylene, butadiene, paraffin, vinyl acetate, or vinyl butyral.

Such polymer dispersions are commercially available or can be prepared based on known methods.

Preferably, those having 1 to 50% by weight of a water-soluble polymer such as polyvinyl alcohol, etc. added in the above water-dispersible emulsion may be used.

Otherwise, it is also possible to use blends of alcohol-soluble nylon with water- or alkaline water-soluble polymer such as blend of alcohol-soluble nylon with water-soluble nylon, blend of phenol resin with alcohol-soluble nylon, blend of hydroxypropylmethyl cellulose phthalate with alcohol-soluble nylon, etc.

However, when the upper layer is a photosensitive layer or a colorant-photosensitive layer, only the binder of (3) cannot be used, but in this case the binder of (3) can be used by adding into (1) and/or (2).

In the above respective layers, in addition to the materials as described above, further plasticizers, coating characteristic enhancers, etc. can be also added.

Examples of plasticizers may include respective low molecular weight compounds, such as, phthalates, triphenyl phosphates, maleates, while examples of coating characteristic enhancers may include surfactants, such as fluorine type surfactants, nonionic surfactants, typically ethylcellulose polyalkylene ether, etc.

For preparation of the image forming material according to the present invention, the layer constituent materials as described above may be dissolved in an appropriate solvent, and coated successively or at the same time on a support subjected to mold release treatment or having the subbing layer as described above.

As the solvent, there may be employed water, methanol, ethanol, acetone, ethyl acetate, methyl cellosolve, ethyl cellosolve, dioxane, methyl ethyl ketone, cyclohexanone, diethylene glycol monomethyl ether, $\gamma$-butyrolactone, tetrahydrofuran, methylene chloride, ethylene chloride, dimethyl sulfoxide, dimethylformamide, etc., which can be used either singly or as a combination of two or more compounds.

The image forming material according to the present invention thus prepared is first subjected to imagewise exposure with an active ray.

For imagewise exposure, various light sources such as ultra-high pressure mercury lamp, tungsten lamp, mercury lamp, xenon lamp, fluorescent lamp, CRT light source, laser light source, etc. may be used.

The image forming material thus subjected to imagewise exposure forms an image with an aqueous developer which permeates through the upper layer (adhesive layer), and does not dissolve the image of the photosensitive layer and can dissolve or lubricate the non-image portion.

Next, the colored image obtained is transferred onto a white paper such as white papers for printing, including art paper, coated paper, pure paper, synthetic paper, etc. Specifically, the colored image is superposed on the white paper and passed through a laminator under heating and pressurization. The colored image is adhered to the white paper to be transferred thereon by the heating and pressurization during passage.

When a mult-color correction sheet is to be prepared, the above steps of exposure, developing and transfer are repeated for the necessary number of colors.

The multi-color correction sheet obtained has only the colored images transferred on the white paper, which is remarkably approximate to a printed matter.

The present invention is described below by referring to Examples, by which the present invention is not limited at all.

Example 1

Four colors of coloration photosensitive dispersions with the composition shown below were prepared and applied on a polyethyleneterephthalate film subjected to mold release treatment (trade name: Tuftop, produced by Toray K.K.) to a dried film thickness of 2 µm.

Photosensitive resin having the following structure (average molecular weight: 800), 1.15 g:

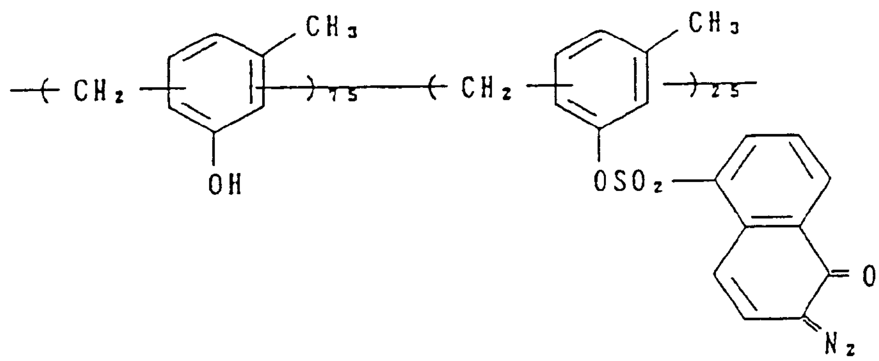

Phenol resin having the following structure (average molecular weight 2,000); 3.85 g:

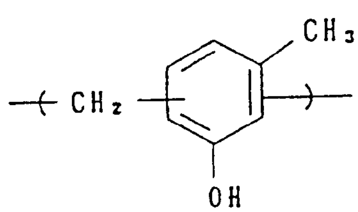

Pigments shown below; 1.5 g
Methyl cellosolve; 25 g
Methyl ethyl ketone; 25 g

(Pigments)

Black: Carbon black #50 (produced by Mitsubishi Kasei K.K.);
Yellow: Chromophthalyellow 8G (produced by Ciba-Geigy Co.);
Magenta: Chromphthalred A ( " );
Cyan: Chromphthalblue 4 GN ( " ).

Next, as the adhesive layer, the emulsion shown below was applied on the coloration photosensitive layer to a dried film thickness of 1 µm.

| | |
|---|---|
| Ethylene-vinyl acetate copolymer emulsion [trade name: OM-28 (containing 10% PVA), produced by Kuraray K.K.] | 5 g |
| Water | 50 g |

Then, in order to enhance adhesion between the coloration photosensitive layer and the adhesive layer, aging was effected at 55 °C for 24 hours.

The image forming materials of the four colors obtained were each superposed on the color resolving positive-mask of each color and subjected to imagewise exposure from the polyethyleneterephthalate film side at a distance of 50 cm from a 3 KW metal halide lamp and then dipped in a 10-fold diluted solution of SDP-1 (Sakura PS plate developer: produced by Konishiroku Photo Industry) for 60 seconds, followed by developing with cellulose sponge, to obtain colored images of four colors.

The yellow color image previously obtained was adhered to an art paper and passed through a pair of nip rolls heated to 100 °C to have the color image transferred onto the art paper. Subsequently, in the order of magenta, cyan and black, color images were transferred to obtain a color proofing sheet comprising four colors on the art paper.

The color proof obtained was found to have only images transferred directly onto the art paper, and remarkably approximate to a printed matter.

Example 2

A support having a mold releasable surface was prepared by applying a coating solution for subbing layer with a composition shown below on a polyethyleneterephthalate film:

| | |
|---|---|
| Alcohol-soluble nylon (trade name: Ultramid lc, produced by BASF Co.) | 2 g |
| Hydroxystyrene (trade name: Resin M, produced by Maruzen Sekiyu Co.) | 2 g |
| Methanol | 40 g |
| Methylcellosolve | 10 g |

Next, four colors of coloration photosensitive layer dispersions with the composition shown below were prepared and applied to a dry film thickenss of 2 μm.

| | |
|---|---|
| Pentaerythritol tetraacrylate | 43.2 g |
| Copolymer of benzyl methacrylate and methacrylic acid (BMA/MA=73/27 molar ratio) | 60 g |
| Micheler's ketone | 0.41 g |
| Benzophenone | 2.54 g |
| P-methoxyphenol | 0.12 g |
| Pigment (the same as in Example 1) | 30 g |
| Methyl cellosolve | 1,000 g |

Next, as the adhesive layer, a coating solution with the following composition was applied on the coloration photosensitive layer to a dried film thickness of 1 μm.

| | |
|---|---|
| Alcohol-soluble nylon (trade name: CM-8000, produced by Toray K.K.) | 2 g |
| Water-soluble nylon (trade name: A-70, produced by Toray K.K.) | 2 g |
| Methanol | 35 g |
| Water | 15 g |

Then, in order to enhance adhesion between the coloration photosensitive layer and the adhesive binder layer, aging was effected at 55 °C for 24 hours.

The image forming materials of four colors obtained were subjected to imagewise exposure from the film surface by use of a color-resolving negative-mask similarly as in Example 1, then dipped in a 3-fold diluted

solution of SDN-21 (Sakura PS plate developer: produced by Konishiroku Photo Industry) for 60 seconds, followed by development with a cellulose sponge, to obtain colored images of four colors.

The colored images obtained were adhered to an art paper and passed through the nip rolls heated to 100 °C similarly as in Example 1 to obtain a color proofing sheet comprising four colors on the art paper.

The color proof obtained was found to have only images transferred directly onto the art paper, and remarkably approximate to a printed matter.

Example 3

The positive-type photosensitive composition used in Example 1 (the composition in which no pigment was added in the coloration photosensitive layer dispersion in Example 1) was applied on a polyethyleneterephthalate film to a dried film thickness of 2 μm.

Next, a pigment was added and dispersed in the following emulsion and applied as the coloration adhesive layer to a dried film thickness of 2 μm.

| | |
|---|---|
| Paraffin wax emulsion (solids: 30%) | 20 g |
| Pigment in Example 1 | 1.2 g |
| Polyvinyl alcohol (trade name: PVA-117, produced by Kuraray K.K.) | 0.3 g |
| Water | 3 g |

By use of the image forming materials of four colors obtained, a color proofing sheet comprising four colors was obtained in the same manner as in Example 1.

The color images of four colors obtained were passed through a pair of nip rolls heated to 100 °C in the order of yellow, magenta, cyan and black to effect transfer of the color images onto an art paper to obtain a color proofing sheet.

During this operation, only the colored adhesive layer was transferred onto the art paper, with the photosensitive layer remaining on the polyethylenetelephthalate film.

The color proof obtained was found to have only images transferred directly onto the art paper, and remarkably approximate to a printed matter.

Example 4

Four colors of coloration photosensitive dispersions with the composition shown below were prepared and applied on a polymethyleneterephthalate film subjected to mold release treatment (trade name: Tuftop, produced by Toray K.K.) to a dried film thickness of 2 μm.

Photosensitive resin having the following structure (A):

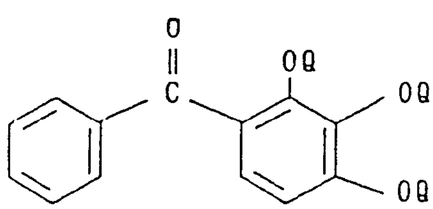

( Q : 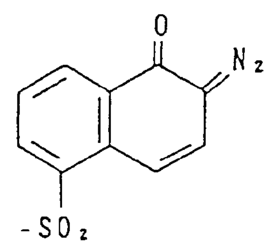 )

Novolac resin having the following structure (average molecular weight 2,000) (B):

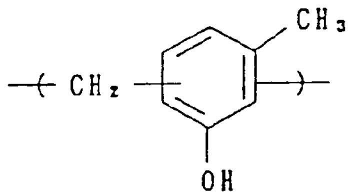

Ethyl cellosolve (EC)

Preparation table (unit: parts by weight)

| | Black | Cyan | Magenta | Yellow |
|---|---|---|---|---|
| (A) | 1.15 | 1.15 | 1.15 | 1.15 |
| (B) | 3.85 | 3.85 | 3.85 | 3.85 |
| (EC) | 42.8 | 39.6 | 40.6 | 40.6 |
| (Pigment) | | | | |
| Carbon black #50 (produced by Mitsubishi Kasei K.K.) | 0.50 | - | - | - |
| Chromphthalblue 4GN (produced by Ciba-Geigy Co.) | - | 0.28 | - | - |
| Chromphthalred A (produced by Ciba-Geigy Co.) | - | - | 0.34 | - |
| Chromophthalyellow 8G (produced by Ciba-Geigy Co.) | - | - | - | 0.34 |

Hereinafter, unit of the components is represented by parts by weight unless otherwise specified.

Next, four colors of coloration adhesive layer dispersions with the compositions shown below were prepared and applied on the coloration photosensitive layer of the same color to a dried film thickness of 1 μm.

Preparation table (unit: parts by weight)

| | Black | Cyan | Magenta | Yellow |
|---|---|---|---|---|
| (Adhesive) | | | | |
| Vinyl acetate emulsion (trade name: Saibinol A, produced by Saiden Kagaku Kagaku K.K.) | 5 | 5 | 5 | 5 |
| Water | 50 | 50 | 50 | 50 |
| (Pigment) | | | | |
| Carbon black #50 (produced by Mitsubishi Kasei K.K.) | 0.49 | - | - | - |
| Chromphthalblue 4GN (produced by Ciba-Geigy Co.) | - | 0.27 | - | - |
| Chromphthalred A (produced by Ciba-Geigy Co.) | - | - | 0.34 | - |
| Chromophthalyellow 8G (produced by Ciba-Geigy Co.) | - | - | - | 0.34 |

Then, in order to enhance adhesion between the coloration photosensitive layer and the coloration adhesive layer, aging was effected at 55 °C for 24 hours.

By use of the image forming materials of four colors obtained, color images of four colors were obtained in the same manner as in Example 1.

The color images of four colors obtained were passed through a pair of nip rolls heated to 100 °C in the order of yellow, magenta, cyan and black to effect transfer of the color images onto an art paper to obtain a color proofing sheet.

The color proof obtained was found to have only images transferred directly onto the art paper, and remarkably approximate to a printed matter.

Example 5

A support subjected to mold release treatment was prepared by laminating a polypropylene film with a thickness of 25 μm (trade name "S:#25", produced by Tokyo Cellophane Paper K.K.) through a polyurethane resin type adhesive on a polyethyleneterephthalate film with a thickness of 50 μm (Trade name: Lumilar T type, produced by Toray K.K.).

Next, the colorant layer dispersions of four colors with the following compositions were applied on the support subjected to mold release treatment to a dried film thickness of 1 μm.

Preparation table (unit: parts by weight)

| | Black | Cyan | Magenta | Yellow |
|---|---|---|---|---|
| (Binder) | | | | |
| Novolac resin having the following structure: (average molecular weight: 2,000) | 5 | 5 | 5 | 5 |
| 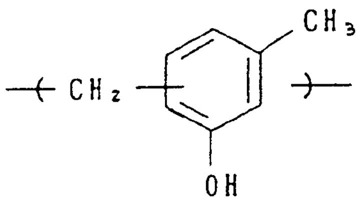 | | | | |
| Ethyl cellosolve (EC) | 42.8 | 39.6 | 40.6 | 40.6 |
| (Pigment) | | | | |
| Carbon black #50 (produced by Mitsubishi Kasei K.K.) | 0.99 | - | - | - |
| Chromphthalblue 4GN (produced by Ciba-Geigy Co.) | - | 0.55 | - | - |
| Chromphthalred A (produced by Ciba-Geigy Co.) | - | - | 0.68 | - |
| Chromophthalyellow 8G (produced by Ciba-Geigy Co.) | - | - | - | 0.68 |

Further, a positive-type photosensitive adhesive solution with the following composition was applied on the colorant layers of the respective colors to a dried film thickness of 1 μm.

| | |
|---|---|
| Binder (4-hydroxyphenylmethacrylamide: acrylonitrile:methyl methacrylate: acrylic acid=15:10:71:4 (mol%), weight average molecular weight Mw=2,000) | 3.85 parts |
| Photosensitive material (1,2-naphthoquinone-2-diazide-5-sulfonic acid ester of 2,3,4-trihydroxybenzophenone) | 1.15 parts |
| Methyl cellosolve (MC) | 39.6 parts |

By use of the image forming materials of four colors obtained, color images of four colors were obtained in the same manner as in Example 1.

The color images of four colors obtained were passed through a pair of nip rolls heated to 100 °C in the order of yellow, magenta, cyan and black to effect transfer of the color images onto an art paper to obtain a color proofing sheet.

The color proof obtained was found to have only images transferred directly onto the art paper, and remarkably approximate to a printed matter.

Example 6

A color proof was prepared in the same manner as in Example 5 except for using the photosensitive colorant layer dispersions with the following compositions in place of the colorant layer dispersions.

Preparation table (unit: parts by weight)

| | Black | Cyan | Magenta | Yellow |
|---|---|---|---|---|
| (Binder) | | | | |
| Novolac resin having the following structure: (average molecular weight: 2,000) | 3.85 | 3.85 | 3.85 | 3.85 |
| 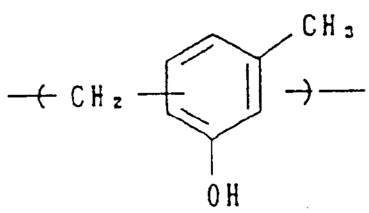 | | | | |
| (Photosensitive material) | | | | |
| (1,2-naphthoquinonediazide-5-sulfonic acid ester of 2,3,4-trihydroxybenzophenone) | 1.15 | 1.15 | 1.15 | 1.15 |
| Ethyl cellosolve (EC) | 42.8 | 39.6 | 40.6 | 40.6 |
| (Pigment) | | | | |
| Carbon black #50 (produced by Mitsubishi Kasei K.K.) | 0.99 | - | - | - |
| Chromphthalblue 4GN (produced by Ciba-Geigy Co.) | - | 0.55 | - | - |
| Chromphthalred A (produced by Ciba-Geigy Co.) | - | - | 0.68 | - |
| Chromophthalyellow 8G (produced by Ciba-Geigy Co.) | - | - | - | 0.68 |

The color proof obtained was found to have only images transferred directly onto the art paper, and remarkably approximate to a printed matter.

Example 7

In the same manner as in Example 5, a support subjected to mold release treatment was prepared.

Next, the colorant layer dispersions of four colors with the following compositions were applied on the support subjected to mold release treatment to a dried film thickness of 1 μm.

Preparation table (unit: parts by weight)

| | Black | Cyan | Magenta | Yellow |
|---|---|---|---|---|
| (Binder) | | | | |
| 4-Hydroxyphenylmethacryl amide:acrylonitrile:methyl methacrylate:acrylic acid =10:10:77:3; weight average molecular weight (Mw):18,000 | 5 | 5 | 5 | 5 |
| Ethyl cellosolve (EC) | 42.8 | 39.6 | 40.6 | 40.6 |
| (Pigment) | | | | |
| Carbon black #50 (produced by Mitsubishi Kasei K.K.) | 0.99 | - | - | - |
| Chromphthalblue 4GN (produced by Ciba-Geigy Co.) | - | 0.55 | - | - |
| Chromphthalred A (produced by Ciba-Geigy Co.) | - | - | 0.68 | - |
| Chromophthalyellow 8G (produced by Ciba-Geigy Co.) | - | - | - | 0.68 |

Further, a positive-type photosensitive adhesive solution with the following composition was applied on the colorant layers of the respective colors onto a dried film thickness of 1 μm.

| | |
|---|---|
| Binder (phenol resin with weight average molecular weight Mw=1,000) | 3.85 parts |
| Photosensitive material (1,2-naphthoquinone-2-diazide-5-sulfonic acid ester of 2,3,4-trihydroxybenzophenone) | 1.15 parts |
| Methyl cellosolve (MC) | 39.6 parts |

By use of the image forming materials of four colors obtained, color images of four colors were obtained in the same manner as in Example 1.

The color images of four colors obtained were passed through a pair of nip rolls heated to 100 °C in the

order of yellow, magenta, cyan and black to effect transfer of the color images onto an art paper to obtain a color proofing sheet.

The color proof obtained was found to have only images transferred directly onto the art paper, and remarkably approximate to a printed matter.

Example 8

A color proof was prepared in the same manner as in Example 7 except for using the photosensitive colorant layer dispersions with the following compositions in place of the colorant layer dispersions.

Preparation table (unit: parts by weight)

| | Black | Cyan | Magenta | Yellow |
|---|---|---|---|---|
| (Binder) | | | | |
| 4-Hydroxyphenylmethacryl amide:acrylonitrile:methyl methacrylate:acrylic acid =10:10:77:3;weight average molecular weight (Mw): 18,000 | 3.85 | 3.85 | 3.85 | 3.85 |
| (Photosensitive material) | | | | |
| (1,2-naphthoquinonediazide-5-sulfonic acid ester of 2,3,4-trihydroxybenzophenone) | 1.15 | 1.15 | 1.15 | 1.15 |
| Ethyl cellosolve (EC) | 42.8 | 39.6 | 40.6 | 40.6 |
| (Pigment) | | | | |
| Carbon black #50 (produced by Mitsubishi Kasei K.K.) | 0.99 | - | - | - |
| Chromphthalblue 4GN (produced by Ciba-Geigy Co.) | - | 0.55 | - | - |
| Chromphthalred A (produced by Ciba-Geigy Co.) | - | - | 0.68 | - |
| Chromophthalyellow 8G (produced by Ciba-Geigy Co.) | - | - | - | 0.68 |

The color proof obtained was found to have only images transferred directly onto the art paper, and remarkably approximate to a printed matter.

Example 9

In the same manner as in Example 5, a support subjected to mold release treatment was prepared.

Next, a binder solution with the following composition was applied on the support subjected to mold release treatment to a dried film thickness of 1 μm.

Phenol resin having the following structure:
(weight average molecular weight: 1,000) 5 parts

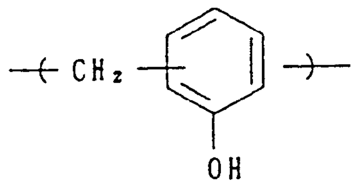

Ethyl cellosolve (EC) 45 parts

Next, the positive-type photosensitive colorant layer dispersions of four colors with the following compositions were applied on the binder layer to a dried film thickness of 1 μm.

Preparation table (unit: parts by weight)

| | Black | Cyan | Magenta | Yellow |
|---|---|---|---|---|
| (Binder) | | | | |
| 4-Hydroxyphenylmethacryl amide:acrylonitrile:methyl methacrylate:acrylic acid =10:10:77:3; weight average molecular weight (Mw): 18,000) | 3.85 | 3.85 | 3.85 | 3.85 |
| (Photosensitive material) | | | | |
| (1,2-naphthoquinone-2-diazide-5-sulfonic acid ester of 2,3,4-trihydroxybenzophenone) | 1.15 | 1.15 | 1.15 | 1.15 |
| Ethyl cellosolve (EC) | 42.8 | 39.6 | 40.6 | 40.6 |
| (Pigment) | | | | |
| Carbon black #50 (produced by Mitsubishi Kasei K.K.) | 0.99 | - | - | - |
| Chromphthalblue 4GN (produced by Ciba-Geigy Co.) | - | 0.55 | - | - |
| Chromphthalred A (produced by Ciba-Geigy Co.) | - | - | 0.68 | - |
| Chromophthalyellow 8G (produced by Ciba-Geigy Co.) | - | - | - | 0.68 |

By use of the image forming materials of four colors obtained, color images of four colors were obtained in the same manner as in Example 1.

The color images of four colors obtained were passed through a pair of nip rolls heated to 100 °C in the order of yellow, magenta, cyan and black to effect transfer of the color images onto an art paper to obtain a color proofing sheet.

The color proof obtained was found to have only images transferred directly onto the art paper, and remarkably approximate to a printed matter.

Example 10

In the same manner as in Example 5, colorant layer dispersions of four colors were applied on the support subjected to mold release treatment to a dried film thickness of 0.5 μm.

Next, the photosensitive colorant layer dispersions used in Example 9 were applied on the colorant layers of the same color to a dried film thickness of 0.5 μm.

By use of the image forming materials of four colors obtained, a color proofing sheet comprising four colors was obtained in the same manner as in Example 1.

The color proof obtained was found to have only images transferred directly onto the art paper, and remarkably approximate to a printed matter.

Example 11

In the same manner as in Example 5, a support subjected to mold release treatment was prepared.

Next, a positive-type photosensitive composition with the following composition was applied on the support subjected to mold release treatment to a dried film thickness of 1 μm.

| | |
|---|---|
| Phenol resin having the following structure: (weight average molecular weight: 1,000) | 3.85 parts |

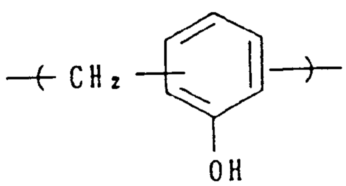

| | |
|---|---|
| (1,2-naphthoquinone-2-diazide-5-sulfonic acid ester of 2,3,4-trihydroxybenzophenone) | 1.15 parts |
| Ethyl cellosolve (EC) | 39.6 parts |

Next, the photosensitive colorant layer dispersions used in Example 9 were applied on the photosensitive composition to a dried film thicknes of 1 μm.

By use of the image forming materials of four colors obtained, a color proofing sheet comprising four colors was obtained in the same manner as in Example 1.

The color proof obtained was found to have only images transferred directly onto the art paper, and remarkably approximate to a printed matter.

Example 12

In the same manner as in Example 5, a support subjected to mold release treatment was prepared.

Next, the photosensitive colorant layer dispersions of four colors used in Example 6 were applied to a dried film thickness of 0.5 μm.

Next, the photosensitive colorant layer dispersions of four colors used in Example 9 were applied on the

photosensitive colorant layers of the same color to a dried film thickness of 0.5 μm.

By use of the image forming materials of four colors obtained, a color proofing sheet comprising four colors were obtained in the same manner as in Example 1.

The color proof obtained was found to have only images transferred directly onto the art paper, and remarkably approximate to a printed matter.

Example 13

On a support subjected to mold release treatment prepared in the same manner as in Example 5, negative-type photosensitive colorant layer dispersions of four colors having the following compositions were applied to a dried film thickness of 1 μm.

Preparation table (unit: parts by weight)

| | Black | Cyan | Magenta | Yellow |
|---|---|---|---|---|
| Diazo resin having the following structural formula: [weight average molecular weight (Mw): about 1,000] 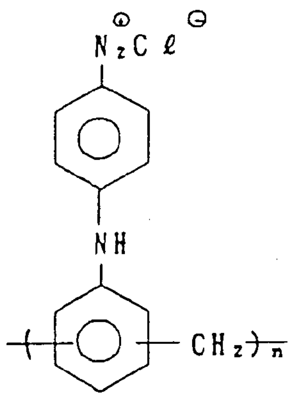 | 1 | 1 | 1 | 1 |
| 4-Hydroxyphenylmethacryl amide:acrylonitrile:methyl methacrylate:acrylic acid =10:10:77:3, weight average molecular weight (Mw): 18,000 | 5 | 5 | 5 | 5 |
| Polyacrylic acid (trade name: (Jucs-AC10C, produced by Nippon Junyaku K.K.) | 0.3 | 0.3 | 0.3 | 0.3 |
| Methyl cellosolve (EC) | 51.4 | 47.5 | 48.7 | 48.7 |
| (Pigment) | | | | |
| Carbon black #50 (produced by Mitsubishi Kasei K.K.) | 1.19 | - | - | - |
| Chromphthalblue 4GN (produced by Ciba-Geigy Co.) | - | 0.66 | - | - |
| Chromphthalred A (produced by Ciba-Geigy Co.) | - | - | 0.82 | - |
| Chromophthalyellow 8G (produced by Ciba-Geigy Co.) | - | - | - | 0.82 |

Next, negative-type photosensitive adhesive solutions with the following compositions were applied on the photosensitive colorant layers of the respective colors to a dried film thickness of 1 μm.

Diazo resin: 1 part

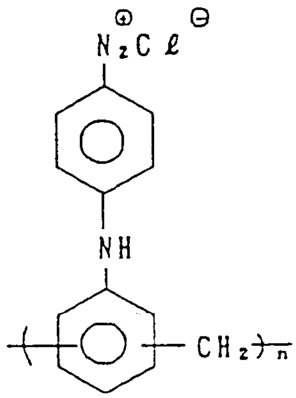

(weight average molecular weight (Mw): about 1,000)

| | |
|---|---|
| Binder 4-Hydroxyphenylmethacrylamide :acrylonitrile:methyl methacrylate :acrylic acid = 15:10:71:4 (mol %); weight average molecular weight (Mw) 2,000 | 5 parts |
| Ethyl cellosolve | 47.5 parts |

The coloration image forming material thus obtained was exposed to a 1 KW metal halide light source from the polyethyleneterephthalate film side for 10 minutes, and then developed for one minute in a developer obtained by dissolving sodium carbonate in one liter of water at 25 °C and adjusting the pH to 9, whereby developing could be done with a low alkaline developer to give a a good image. Thus, color images of four colors were obtained.

The color images obtained were adhered onto an art paper and were passed through a pair of nip rolls heated to 100 °C in the same manner as in Example 1 to obtain a color proofing sheet comprising 4 colors on the art paper.

The color proof obtained was found to have only images transferred directly onto the art paper, and remarkably approximate to a printed matter.

Example 14

On a support subjected to mold release treatment prepared in the same manner as in Example 5, the photosensitive colorant layer dispersions of four colors used in Example 8 were applied to a dried film thickness of 1 μm.

Next, the positive-type photosensitive adhesive solutions used in Example 5 were applied on the photosensitive colorant layers of the respective colors to a dried film thickness of 1 μm.

By use of the imge forming materials of four colors thus obtained, color images of four colors were obtained in the same manner as in Example 13.

The color images obtained were adhered onto an art paper and were passed through a pair of nip rolls heated to 100 °C in the same manner as in Example 1 to obtain a color proofing sheet comprising 4 colors on the art paper.

The color proof obtained was found to have only images transferred directly onto the art paper, and remarkably approximate to a printed matter.

Comparative example 1

A color proofing sheet was prepared in the same manner as in Example 4 in Japanese Unexamined Patent Publication No. 41830/1972.

A specific example is shown below.

An ethyl acetate solution of a copolymer of vinyl chloride and vinyl acetate was coated on a polyester film and then dried to prepare a color image backing layer, followed by coating and drying of a solution with a composition:

| | |
|---|---|
| O-naphthoquinonediazide sulfonic acid ester | 2 g |
| Phenol formaldehyde novolac | 1 g |
| Oil yellow 5G (oily dye) | 0.5 g |
| Acetone | 40 g |
| Methyl cellosolve | 60 g |

to prepare a photosensitive heat transfer sheet for yellow.

By use of Zabon Fast Red BB, Zabon Fast Blue HFL and Oil Black HB in place of the oily dye Oil Yellow 5G, heat transfer sheets for magenta, cyan and black were prepared similarly.

The heat transfer sheets of the respective colors were adhered to the corresponding color resolving net positives, respectively, exposed to xenon arc lamp, dipped in an alkaline developer to remove the photosensitive layers at the exposed portions, washed with water and dried to obtain the respective color images. The color image formed heat transfer sheet was superposed on a coated paper and pressed by passing between a metal roller heated to 100 °C and a rubber roller contacted therewith, followed by peel-off of the polyester film. As the result, the color image was transferred together with the color image backing layer onto the coated paper surface. By repeating this procedure similarly for the respective color image sheets, a multi-color image was obtained.

The color proofing sheet obtained, which was wholly covered with the color image backing layer, was found to be as shown in the photograph. For making the transferred image approximate to that of a printed matter, it is at least required to effect matting.

As described above, according to the present invention, the treating process becomes simpler and also a transferred image approximate to a printed matter can be obtained.

## Claims

1. A multi-color transfer image forming method, which comprises subjecting to imagewise exposure an image forming material having a support and a recording layer thereon, characterized in that said recording layer comprises two layers including a colorant and photosensitive material whose solubility with respect to aqueous based solutions changes on exposure to actinic radiation, the layer which is remotest from the support on which the recording layer is applied, being adhesive to an image receiving member; the material is developed using an aqueous developer, leaving the support exposed in the non image parts and leaving a colored image in the image parts, said material is laminated to an image receiving member with peel-off of the support, so that said colored image adheres to the image receiving member with the outermost adhesive layer of said colored image, and thereafter at least one further image obtained by exposure and development of said image forming material, having a colorant of a different hue is transferred to said same image receiving member having said colored image thereon whereby a surface of said image receiving member is left exposed in non-image portions of said multi-color transfer image.

2. A multi-color transfer image forming method according to claim 1, characterized in that said photosensitive material is a photocrosslinkable type photosensitive resin system; a system comprising a mixture of a diazonium salt or its condensate with polyvinyl alcohol, polyvinyl pyrrolidine or polyacrylamide; a system in which an aromatic azide compound is used as the photocrosslinkable agent and mixed with a binder; a photosensitive resin utilizing photoradical polymerization or photoionic polymerization; and a photosolubilizing resin system.

3. The multi-color transfer image forming method according to claim 1, characterized in that said photosensitive material is a quinonediazide compound.

4. The multi-color transfer image forming method according to claim 3, characterized in that said photosensitive material is a compound obtained by the condensation of
1,2-benzoquinonediazide-4-sulfonyl chloride,
1,2-naphthoquinonediazide-4-sulfonyl chloride,
1,2-naphthoquinonediazide-6-sulfonyl chloride, or
1,2-naphthoquinonediazide-6-sulfonyl chloride with hydroxyl group- and/or amino group-containing compounds.

5. The multi-color transfer image forming method according to claim 4, characterized in that said hydroxyl group-containing compound is trihydroxybenzophenone, dihydroxyanthraquinone, bisphenol A, phenol novalac resin, resorcin benzaldehyde condensed resin, and said amino group-containing compound is aniline, p-aminodiphenylamine, p-aminobenzophenone, 4,4′-diaminodiphenylamine or 4,4-diaminobenzophenone.

6. The multi-color transfer image forming method according to claim 1, characterized in that said recording layer further contains a binder.

7. The multi-color transfer image forming method according to claim 6, characterized in that said binder is a polymeric compound which can form a film and is soluble in a solvent, and can be dissolved or swelled in the developer.

8. The multi-color transfer image forming method according to claim 7, characterized in that said binder is at least one of acrylic acid or methacrylic acid and alkyl ester or sulfoalkyl ester thereof; phenol resin; polyvinyl butyral; polyacrylamide; cellulose derivatives; polystyrene, polyvinyl chloride, chlorinated rubber, polyisobutylene, polybutadiene and polyvinyl acetate and their coplymers; cellulose acetate; cellulose propionate; and cellulose acetate phthalate.

9. The multi-color transfer image forming method according to claim 7, characterized in that said binder which constitutes the upper layer of the recording layer is (1) a novolac resin having a weight average molecular weight (Mw) of 3.500 to 500 and a number average molecular weight (Mn) of 1.000 to 200; (2) a copolymer containing at least one of phenolic hydroxy group, alcoholic hydroxyl group and carboxylic group; or (3) compounds comprising a heat-fusible polymer, having water permeability and water insolubility.

10. The multi-color transfer image forming method according to claim 9, characterized in that said novolac resin is a phenol resin.

11. The multi-color transfer image forming method according to claim 1, characterized in that said support is a polyester film, an acetate film, a polyvinylchloride film, a polystyrene film or a polypropylene film.

12. The multi-color transfer image forming method according to claim 1, characterized in that the support is subjected to mold release treatment with oil repellent substance or provided with a subbing layer.

13. The multi-color transfer image forming method according to claim 12, characterized in that said oil repellent substance is silicone oil, fluorine resin, fluorine type surfactant, polyolefin or polyamide.

14. The multi-color transfer image forming method according to claim 12, characterized in that said subbing layer is made of alcohol-soluble polyamide, alcohol-soluble nylon, a blend of partially esterified resin of a copolymer of styrene and maleic anhydride with methoxymethylated nylon, polyvinyl acetate, polyacrylate, copolymer of vinyl chloride and vinyl acetate, polyvinyl butyrate, cellulose acetate phthalate, methyl cellulose, cellulose triacetate or polyvinyl alcohol.

15. The multi-color transfer image forming method according to claim 1, characterized in that the layer in the recording layer which is remotest from the support contains a binder and the other layer thereof contains the photosensitive material and the colorant.

16. The multi-color transfer image forming method according to claim 15, characterized in that said binder

comprises a heat-fusible polymer having water permeability and water insolubility.

17. The multi-color transfer image forming method according to claim 16, characterized in that said binder is a water-dispersible emulsion.

18. The multi-color transfer image forming method according to claim 17, characterized in that said water-dispersible emulsion is a single component polymer or copolymer of acrylic and methacrylic acid esters or vinyl esters.

19. The multi-color transfer image forming method according to claim 18, characterized in that said water-dispersible emulsion is at least one of methyl ester, ethyl ester, butyl ester, isobutyl ester, hexyl ester, decyl ester, lauryl ester, stearyl ester, cyclohexyl ester, vinyl acetate, vinyl propionate, vinyl isononanate, vinyl benzathate, ethylene, dibutylmaleinate, styrol, vinyl chloride, vinyl isobutyl ether, isobutylene, butadiene, paraffin, vinyl acetate and vinyl butyral.

20. The multi-color transfer image forming method according to claim 19, characterized in that said water-dispersible emulsion contains a water-soluble polymer in an amount of 1 to 50 % by weight.

21. The multi-color transfer image forming method according to claim 1, characterized in that the layer in the recording layer which is remotest from the support contains the photosensitive material and the other layer contains the colorant.

22. The multi-color transfer image forming method according to claim 1, characterized in that the layer in the recording layer which is remotest from the support contains the photosensitive material and the other layer thereof contains the photosensitive material and the colorant.

**Patentansprüche**

1. Mehrfarben-Bildübertragungsverfahren, bei dem man ein Abbildungsmaterial mit einem Träger und einer Aufzeichnungsschicht darauf einer bildweisen Belichtung unterzieht, dadurch gekennzeichnet, daß diese Aufzeichungsschicht zwei ein Farbmittel und lichtempfindliches Material einschließende Schichten umfaßt, dessen Löslichkeit in Lösungen auf wäßriger Grundlage sich bei Belichtung mit aktinischer Strahlung verändert, wobei die vom Träger am weitesten entfernte Schicht mit der darauf aufgebrachten Aufzeichnungsschicht an einem Bildempfangsglied anhaftet, das Material mit einem wäßrigen Entwickler entwickelt wird, der den Träger an den Nichtbildstellen freilegt und an den Bildstellen ein Farbbild hinterläßt, dieses Material mit einem vom Träger abziehbaren Bildempfangsglied kaschiert ist, so daß dieses Farbbild an dem Bildempfangsglied mit seiner äußersten Klebeschicht anhaftet, und danach mindestens eine weitere, durch Belichtung und Entwicklung jenes Abbildungsmaterials mit einem Farbmittel eines anderen Farbtons erzeugte Abbildung auf dasselbe Bildempfangsglied mit besagtem Farbbild darauf übertragen wird, wobei eine Fläche jenes Bildempfangsglieds an den Nichtbildstellen dieses Mehrfarben-Übertragungsbilds frei bleibt.

2. Mehrfarben-Bildübertragungsverfahren nach Anspruch 1, dadurch gekennzeichnet, daß dieses lichtempfindliche Material ein lichtempfindliches Harzsystem vom lichtvernetzbaren Typ, ein aus einem Gemisch aus einem Diazoniumsalz oder dessen Kondensat mit Polyvinylalkohol, Polyvinylpyrrolidon oder Polyacrylamid bestehendes System, ein System in welchem eine mit einem Bindemittel vermischte aromatische Azidverbindung als lichtvernetzbares Mittel verwendet wird, ein Photoradikalpolymerisation oder Photoionenpolymerisation benutzendes lichtempfindliches Harz oder ein durch Licht löslichmachendes Harzsystem ist.

3. Mehrfarben-Bildübertragungsverfahren nach Anspruch 1, dadurch gekennzeichnet, daß dieses lichtempfindliche Material eine Chinondiazidverbindung ist.

4. Mehrfarben-Bildübertragungssystem nach Anspruch 3, dadurch gekennzeichnet, daß dieses lichtempfindliche Material eine durch Kondensation von
1,2-Benzochinondiazid-4-sulfonylchlorid,
1,2-Naphthochinondiazid-4-sulfonylchlorid,
1,2-Naphthochinondiazid-6-sulfonylchlorid oder

1,2-Naphthochinondiazid-6-sulfonylchlorid mit Hydroxyl- und/oder Aminogruppen enthaltenden Verbindungen erhaltene Verbindung ist.

5. Mehrfarben-Bildübertragungsverfahren nach Anspruch 4, dadurch gekennzeichnet, daß diese Hydroxylgruppen enthaltende Verbindung Trihydroxybenzophenon, Dihydroxyanthrachinon, Bisphenol-A, Phenolnovolakharz oder mit Benzaldehyd kondensiertes Resorcinharz und diese Aminogruppen enthaltende Verbindung Anilin, p-Aminodiphenylamin, p-Aminobenzophenon, 4,4′-Diaminodiphenylamin oder 4,4′-Diaminobenzophenon ist.

6. Mehrfarben-Bildübertragungsverfahren nach Anspruch 1, dadurch gekennzeichnet, daß jene Aufzeichnungsschicht ferner ein Bindemittel enthält.

7. Mehrfarben-Bildübertragungsverfahren nach Anspruch 6, dadurch gekennzeichnet, daß dieses Bindemittel eine polymere Verbindung ist, die einen Film bilden kann, in einem Lösungsmittel löslich ist und im Entwickler aufgelöst oder gequollen werden kann.

8. Mehrfarben-Bildübertragungsverfahren nach Anspruch 7, dadurch gekennzeichnet, daß dieses Bindemittel mindestens 1 aus der Gruppe Acryl- oder Methacrylsäure und deren Alkylester oder Sulfoalkylester, Phenolharz, Polyvinylbutyral, Polyacrylamid, ein Zellulosederivat, Polystyrol, Polyvinylchlorid, chlorierter Kautschuk, Polyisobutylen, Polybutadien und Polyvinylacetat und deren Copolymere, Zelluloseacetat, Zellulosepropionat und Zelluloseacetatphthalat ist.

9. Mehrfarben-Bildübertragungsverfahren nach Anspruch 7, dadurch gekennzeichnet, daß dieses, die Oberschicht der Aufzeichnungsschicht darstellende Bindemittel (1) ein Novolakharz mit einem gewichtsmittleren Molekulargewicht (Mw) von 3500 bis 500 und einem zahlenmittleren Molekulargewicht (Mn) von 1000 bis 200, (2) ein mindestens 1 aus der Reihe phenolische Hydroxylgruppe, alkoholische Hydroxylgruppe und Carboxylgruppe enthaltendes Copolymer oder (3) eine ein heißschmelzbares Polymer mit Wasserdurchlässigkeit und -unlöslichkeit enthaltende Masse ist.

10. Mehrfarben-Bildübertragungsverfahren nach Anspruch 9, dadurch gekennzeichnet, daß dieses Novolakharz ein Phenolharz ist.

11. Mehrfarben-Bildübertragungsverfahren nach Anspruch 1, dadurch gekennzeichnet, daß jener Träger ein Polyester-, Acetat-, Polyvinylchlorid-, Polystyrol- oder Polypropylenfilm ist.

12. Mehrfarben-Bildübertragungsverfahren nach Anspruch 1, dadurch gekennzeichnet, daß der Träger einer Entformungsbehandlung mit einer ölabweisenden Substanz unterzogen oder mit einer Substrierschicht versehen wird.

13. Mehrfarben-Bildübertragungsverfahren nach Anspruch 12, dadurch gekennzeichnet, daß diese ölabweisende Substanz ein Silikonöl, ein fluorhaltiges Harz oder ein Tensid, Polyolefin oder Polyamid vom fluorhaltigen Typ ist.

14. Mehrfarben-Bildübertragungsverfahren nach Anspruch 12, dadurch gekennzeichnet, daß diese Substrierschicht aus alkohollöslichem Polyamid, alkohollöslichem Nylon, einem Gemenge aus teilweise verestertem Harz eines Copolymeren aus Styrol und Maleinsäureanhydrid mit methoxymethyliertem Nylon, Polyvinylacetat, Polyacrylat, einem Copolymer aus Vinylchlorid und Vinylacetat, Polyvinylbutyrat, Zelluloseacetatphthalat, Methylzellulose, Zellulosetriacetat oder Polyvinylalkohol hergestellt wird.

15. Mehrfarben-Bildübertragungsverfahren nach Anspruch 1, dadurch gekennzeichnet, daß die in der Aufzeichungs schicht vom Träger am weitesten entfernte Schicht ein Bindemittel sowie deren andere Schicht das lichtempfindliche Material und das Farbmittel enthält.

16. Mehrfarben-Bildübertragungsverfahren nach Anspruch 15, dadurch gekennzeichnet, daß dieses Bindemittel aus einem heißschmelzbaren Polymeren mit Wasserdurchlässigkeit und Wasserunlöslichkeit besteht.

17. Mehrfarben-Bildübertragungsverfahren nach Anspruch 16, dadurch gekennzeichnet, daß dieses Bindemittel eine in Wasser dispergierbare Emulsion ist.

**18.** Mehrfarben-Bildübertragungsverfahren nach Anspruch 17, dadurch gekennzeichnet, daß diese in Wasser dispergierbare Emulsion ein Einkomponentenpolymer oder -copolymer aus Acryl- und Methacrylsäureestern oder Vinylestern ist.

**19.** Mehrfarben-Bildübertragungsverfahren nach Anspruch 18, dadurch gekennzeichnet, daß diese in Wasser dispergierbare Emulsion mindestens 1 aus der Reihe Methylester, Ethylester, Butylester, Isobutylester, Hexylester, Decylester, Laurylester, Stearylester, Cyclohexylester, Vinylacetat, Vinylpropionat, Vinylisononanoat, Vinylbenzoat, Ethylen, Dibutylmaleinat, Styrol, Vinylchlorid, Vinylisobutylether, Isobutylen, Butadien, Paraffin, Vinylacetat und Vinylbutyral enthält.

**20.** Mehrfarben-Bildübertragungsverfahren nach Anspruch 19, dadurch gekennzeichnet, daß diese in Wasser dispergierbare Emulsion ein wasserlösliches Polymer in einer Menge von 1 bis 50 Gewichtsprozent enthält.

**21.** Mehrfarben-Bildübertragungsverfahren nach Anspruch 1, dadurch gekennzeichnet, daß die in der Aufzeichnungsschicht am weitesten vom Träger entfernte Schicht das lichtempfindliche Material und die andere Schicht das Farbmittel enthält.

**22.** Mehrfarben-Bildübertragungsverfahren nach Anspruch 1, dadurch gekennzeichnet, daß die in der Aufzeichnungsschicht vom Träger am weitesten entfernte Schicht das lichtempfindliche Material und die andere Schicht davon das lichtempfindliche Material und das Farbmittel enthält.

## Revendications

**1.** Procédé pour former une image par transfert en plusieurs couleurs, qui comprend l'exposition conforme à une image d'un matériel formateur d'images comprenant un support et une couche d'enregistrement par-dessus, caractérisé en ce que ladite couche d'enregistrement comprend deux couches incluant un colorant et une matière photosensible dont la solubilité par rapport à des solutions à base aqueuse se modifie par exposition à du rayonnement actinique, la couche qui est la plus éloignée du support sur lequel la couche d'enregistrement est appliquée étant adhésive pour un organe récepteur d'image, le matériel est développé à l'aide d'un révélateur aqueux laissant le support exposé dans les parties de non-image et laissant une image colorée dans les parties d'image, ledit matériel est stratifié sur un organe récepteur d'image qui est séparé du support par pelage de façon que l'image colorée adhère à l'organe récepteur d'image par la couche adhésive extérieure de ladite image colorée, et ensuite au moins une image supplémentaire obtenue par exposition et développement de ce matériel formateur d'images, ayant un colorant d'une nuance différente est transférée sur ledit organe récepteur d'image portant ladite image colorée de façon qu'une surface dudit organe récepteur d'image soit laissée exposée dans les parties de non-image de ladite image par transfert en plusieurs couleurs.

**2.** Procédé pour former une image par transfert en plusieurs couleurs suivant la revendication 1, caractérisé en ce que ledit matériel photosensible est un système de résine photosensible du type photoréticulable; un système comprenant un mélange d'un sel de diazonium ou de son produit de condensation avec l'alcool polyvinylique, la polyvinylpyrrolidine ou le polyacrylamide; un système dans lequel un composé azidoaromatique est utilisé comme agent photoréticulable et mélangé avec un liant; une résine photosensible utilisant la polymérisation photoradicalaire ou la polymérisation photoionique; et un système de résine photosolubilisante.

**3.** Procédé pour former une image par transfert en plusieurs couleurs suivant la revendication 1, caractérisé en ce que ledit matériel photosensible est un composé quinonediazide.

**4.** Procédé pour former une image par transfert en plusieurs couleurs suivant la revendication 3, caractérisé en ce que ledit matériel photosensible est un composé obtenu par condensation de chlorure de 1,2-benzoquinonediazide-4-sulfonyle, de chlorure de 1,2-naphtoquinone-diazide-4-sulfonyle, de chlorure de 1,2-naphtoquinone-diazide-6-sulfonyle ou de chlorure de 1,2-naphtoquinone-diazide-6-sulfonyle avec des composés contenant des radicaux hydroxyle et/ou des radicaux amino.

**5.** Procédé pour former une image par transfert en plusieurs couleurs suivant la revendication 4, caractérisé en ce que ledit composé contenant des radicaux hydroxyle est la trihydroxybenzophénone, la dihydroxyanthraquinone, le bisphénol-A, une résine Novalaque au phénol, une résine résorcine-benzaldéhyde condensée et le composé contenant des radicaux amino est l'aniline, la p-aminodiphénylamine, la p-aminobenzophénone, la 4,4′-diaminodiphénylamine ou la 4,4′-diaminobenzophénone.

6. Procédé pour former une image par transfert en plusieurs couleurs suivant la revendication 1, caractérisé en ce que ladite couche d'enregistrement comprend de plus un liant.

7. Procédé pour former une image par transfert en plusieurs couleurs suivant la revendication 6, caractérisé en ce que ledit liant est un composé polymère qui peut former un film qui est soluble dans un solvant et qui peut être dissous ou gonflé dans le révélateur.

8. Procédé pour former une image par transfert en plusieurs couleurs suivant la revendication 7, caractérisé en ce que ledit liant est au moins l'un d'entre l'acide acrylique ou l'acide méthacrylique et leurs esters alcoyliques ou sulfoalcoyliques; une résine phénolique, le polyvinylbutyral, le polyacrylamide; les dérivés de la cellulose; le polystyrène, le poly(chlorure de vinyle), le caoutchouc chloré, le polyisobutylène, le polybutadiène et le poly(acétate de vinyle) et leurs copolymères; l'acétate de cellulose; le propionate de cellulose et l'acétophtalate de cellulose.

9. Procédé pour former une image par transfert en plusieurs couleurs suivant la revendication 7, caractérisé en ce que ledit liant qui constitue la couche supérieure de la couche d'enregistrement est :
(1) une résine Novolaque ayant un poids moléculaire moyen en masse (Mw) de 3500 à 500 et un poids moléculaire moyen en nombre (Mn) de 1000 à 200;
(2) un copolymère contenant au moins l'un d'entre un radical hydroxyle phénolique, un radical hydroxyle alcoolique et un radical carboxylique, ou
(3) les composés comprenant un polymère fusible à chaud-ayant de la perméabilité pour l'eau et de l'insolubilité dans l'eau.

10. Procédé pour former une image par transfert en plusieurs couleurs suivant la revendication 9, caractérisé en ce que ladite résine Novolaque est une résine phénolique.

11. Procédé pour former une image par transfert en plusieurs couleurs suivant la revendication 1, caractérisé en ce que ledit support est un film de polyester, un film d'acétate, un film de poly(chlorure de vinyle), un film de polystyrène ou un film de polypropylène.

12. Procédé pour former une image par transfert en plusieurs couleurs suivant la revendication 1, caractérisé en ce que le support est soumis à un traitement de démoulage avec une substance oléophobe ou est muni d'un substratum.

13. Procédé pour former une image par transfert de plusieurs couleurs suivant la revendication 12, caractérisé en ce que ladite substance oléophobe est l'huile de silicone, une résine fluorée, un tensioactif de type fluoré, une polyoléfine ou un polyamide.

14. Procédé pour former une image par transfert en plusieurs couleurs suivant la revendication 12, caractérisé en ce que le substratum est fait de polyamide soluble dans l'alcool, de nylon soluble dans l'alcool, d'un mélange de résine partiellement estérifiée d'un copolymère de styrène et d'anhydride maléique avec du nylon méthoxyméthylé, du poly(acétate de vinyle), du polyacrylate, le copolymère de chlorure de vinyle et d'acétate de vinyle, du poly(butyrate de vinyle), d'acétophtalate de cellulose, de méthylcellulose, de triacétate de cellulose ou d'alcool polyvinylique.

15. Procédé pour former une image par transfert en plusieurs couleurs suivant la revendication 1, caractérisé en ce que la couche dans la couche d'enregistrement qui est la plus éloignée du support contient un liant et l'autre couche de celle-ci contient le matériel photosensible et le colorant.

16. Procédé pour former une image par transfert en plusieurs couleurs suivant la revendication 15, caractérisé en ce que ledit liant comprend un polymère fusible à chaud ayant de la perméabilité à l'eau et de l'insolubilité dans l'eau.

17. Procédé pour former une image par transfert en plusieurs couleurs suivant la revendication 16, caractérisé en ce que ledit liant est une émulsion susceptible d'être dispersée dans l'eau.

**18.** Procédé pour former une image par transfert en plusieurs couleurs suivant la revendication 17, caractérisé en ce que ladite émulsion susceptible d'être dispersée dans l'eau est un polymère à composant unique ou un copolymère d'esters d'acide acrylique et d'acide méthacrylique ou d'esters vinyliques.

**19.** Procédé pour former une image par transfert en plusieurs couleurs suivant la revendication 18, caractérisé en ce que l'émulsion susceptible d'être dispersée dans l'eau est au moins l'émulsion d'ester méthylique, d'ester éthylique, d'ester butylique, d'ester isobutylique, d'ester hexylique, d'ester décylique, d'ester laurylique, d'ester stéarylique, d'ester cyclohexylique, d'acétate de vinyle, de propionate de vinyle, d'isononanoate de vinyle, de benzathate de vinyle, d'éthylène, de maléate de dibutyle, de styrène, de chlorure de vinyle, d'éther vinylique d'isobutyle, d'isobutylène, de butadiène, de paraffine, d'acétate de vinyle et de vinylbutyral.

**20.** Procédé pour former une image par transfert en plusieurs couleurs suivant la revendication 19, caractérisé en ce que ladite émulsion susceptible d'être dispersée dans l'eau contient un polymère soluble dans l'eau en une quantité de 1 à 50% en poids.

**21.** Procédé pour former une image par transfert en plusieurs couleurs suivant la revendication 1, caractérisé en ce que la couche dans la couche d'enregistrement, qui est la plus éloignée du support, contient le matériel photosensible et l'autre couche contient le colorant.

**22.** Procédé pour former une image par transfert en plusieurs couleurs suivant la revendication 1, caractérisé en-ce que la couche dans la couche d'enregistrement, qui est la plus éloignée du support, contient le matériel photosensible et l'autre couche de celle-ci contient le matériel photosensible et le colorant.

FIG. 1

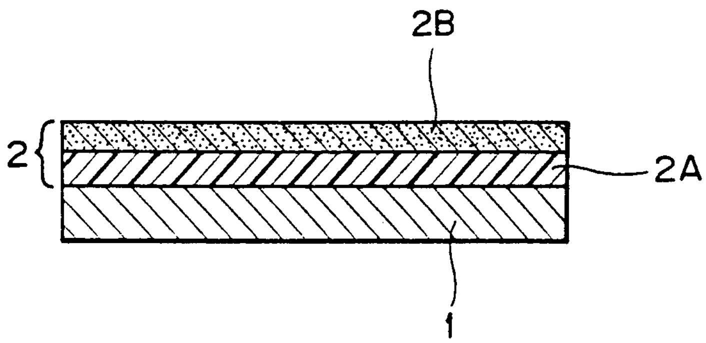


FIG. 2